# EUROPEAN PATENT APPLICATION

(11) **EP 2 119 812 A1**
(43) Date of publication of application: **18.11.2009**
(21) Application number: 07860189.5
(22) Date of filing: 26.12.2007
(51) Int. Cl.: C23C 26/00

(54) **COMPOSITE MATERIAL FOR ELECTRIC AND ELECTRONIC COMPONENTS, ELECTRIC AND ELECTRONIC COMPONENTS, AND METHOD FOR MANUFACTURING COMPOSITE MATERIAL FOR ELECTRIC AND ELECTRONIC COMPONENTS**

(30) Priority: 27.12.2006 JP 2006350875; 25.12.2007 JP 2007333316
(71) Applicant: FURUKAWA ELECTRIC CO., LTD., Tokyo 100-8322 (JP)
(72) Inventor: SUGAHARA, Chikahito, Tokyo 100-8322 (JP); ZAMA, Satoru, Tokyo 100-8322 (JP)
(74) Representative: Reinhard - Skuhra - Weise & Partner GbR
(86) International application number: PCT/JP2007/074960
(87) International publication number: WO 2008/078776

(57) **Abstract**

The invention provides a composite material for use as a material for electric / electronic components, formed by punching, followed by bending. The composite material includes a metallic base material, an insulating film having a substantially single-layer structure provided on at least a part of the metallic base material, and a metal layer provided between the metallic base material and the insulating film so that a peeling width of the insulating film at the end of the material after punching is less than 10 µm, and, after bending, both the adhesion of the insulating film on the inner side of the bent material are retained. The invention also provides electric / electronic components using the composite material and a method for manufacturing the composite material for use in the electric / electronic components.

## Description

### TECHNICAL FIELD

The present invention relates to a composite material for use in electric / electronic components provided with an electrical insulating film on a metallic base material, to electric /electronic components and to a method for manufacturing the composite material for use in the electric / electronic components.

### BACKGROUND ART

A metal material provided with an electric insulating film (also referred to simply as an insulating film in the present invention) on a metallic base material is utilized as a shielding material in a circuit board for example. This metal material is supposed to be suitably used for a case, a cover, a cap and the like and to be especially suitably used for a case in which height of an internal space thereof is lowered to contain devices.

Still more, as a method for enhancing adhesion of the metallic base material and the insulating film of the metal material coated with the insulating film, there have been known such methods of applying a coupling agent on the surface of the metallic base material and of forming a plating layer having a dendrite crystal on the surface of the metallic base material.

### DISCLOSURE OF THE INVENTION

When the metal material provided with the insulating film on the metallic base material is applied as a material for other electric / electronic components, the material may be variously applied because it allows contacts of a connector or the like to be disposed with a narrow pitch by forming the contacts of the connector by carrying out machining such as punching at spots including an interface of the metallic base material with the insulating film because the insulating film is provided on the metallic base material. It is also conceivable to apply it to electric / electronic components having various functions by carrying out bending after punching.

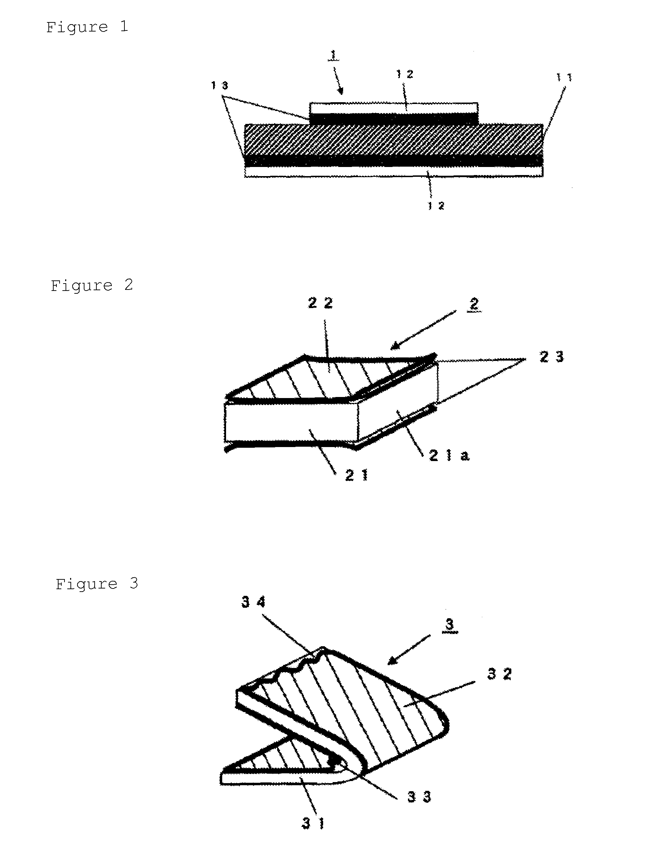

By the way, there is a case when a slight gap of around several µm to several tens µm is created between the metallic base material and the insulating film at the machined spot when the machining such punching is carried out on the spots including the interface between the metallic base material and the insulating film. FIG. 2 schematically shows this state. In FIG. 2, an electric /electronic component 2 includes a metallic base material 21 and a insulating film 22 and has a gap 23 created between the metallic base material 21 and the insulating film 22 near a punched surface 21a of the 21. This tendency increases when a clearance in punching is large, e.g., 5 % or more of a thickness of the metallic base material). Because there is a limit practically to reduce the clearance in punching, this tendency may be said to increase when a workpiece is miniaturized.

The insulating film 22 is peeled totally from the metallic base material 21 in this state due to secular changes and others and it is meaningless to provide the insulating film 22 on the metallic base material 21. Still more, it is not practical to apply the insulating film after micromachining because it is extremely laborious, thus increasing costs of the product. Further, although it is conceivable to apply a metal layer to a metal exposed face, e.g., the punched surface 21a, by means of plating or the like when the metal exposed layer, e.g., the metallic base material 21, of the electric / electronic component thus formed is used as the contact of the connector or the like, there is a possibility that a plating solution enhances the peeling tendency of the insulating film 22 from the metallic base material 21 by infiltrating from the gap 23 when the electric / electronic component is soaked into the plating solution.

Still more, when bending is carried out after punching or the like, there is a possibility that a gap is created between the metallic base material and the insulating film after bending even if there is no gap between the metallic base material and the insulating film at the punched part in the stage of punching. FIG. 3 schematically shows this state. In FIG. 3, an electric /electronic component 3 includes a metallic base material 31 and an insulating film 32 and has a gap 33 formed at an inner side of the bent part of the metallic base material 31 and a 34 formed at an end of the electric / electronic component 3 (an outer side in particular when the electric / electronic component is bent). As shown in FIG. 3, these gaps 33 and 34 show up at sides and an inner surface of the bent part and at the end of the bent electric /electronic component and possibly cause peeling of the insulating film 32 from the metallic base material 31.

Still more, when the method of applying the coupling agent on the surface of the metallic base material is applied as a method for enhancing the adhesion between the metallic base material and the insulating film, there is a problem that the solution must be carefully controlled because a life of the solution of the coupling agent is short. There is also another problem that the coupling agent is not effective to the small gap described above because it is difficult to homogeneously treat the whole surface of the metallic base material. When the method of forming the plated layer having the dendrite crystal on the surface of the metallic base material is applied, it is necessary to plate the layer under a limited plating condition to control the crystal state of the plated layer thus formed while fully paying attention to its control. Further, it is not economical because a thickness of the plating must be thickened more in order to obtain enough adhesion.

The present invention seeks to provide a composite material for use in electric / electronic components that keeps a high adhesion state between a metallic base material and an insulating film even if machining such as punching is carried out at parts including an interface of the metallic base material with the insulating film. In addition, the invention provides electric /electronic components formed by this composite material and a method for manufacturing the composite material for use in the electric / electronic components.

As a result of ardent study, the inventor et al. found that an enough adhesion may be obtained between the metallic base material and the insulating film by providing the insulating film on the metallic base material through a specific metal layer, regardless of a crystal state or thickness of the metal layer, and consummated the present invention by advancing the study further.
That is, the invention provides the following first through ninth solutions.
The first solution provides a composite material for use as a material in electric / electronic components formed by punching followed by bending and provided substantially with one layer of an insulating film at least on part of a metallic base material, wherein a metal layer is provided between the metal layer and the insulating film so that a peel width of the insulating film at an end of the material after punching is less than 10 µm and so that an adhesion state of the insulating film in a bending inner side of the material after bending and an adhesion state of the insulating film at the end to which the bending outer side is extended are both kept.

The second solution is characterized in that the metallic base material is made of copper material or ferric material in the first solution.

The third solution is characterized in that a thickness of the metallic base material is from 0.04 to 0.4 mm in the first or second solution.

The fourth solution is characterized in that the metal layer is made of a metal selected among Ni, Zn, Fe, Dr, Sn, Si and Ti or of an alloy of those metals in the first solution.

The fifth solution is characterized in that a thickness of the metal layer is from 0.001 to 0.5 µm in the first solution.

The sixth solution of the invention is characterized in that the insulating film is made of a heat hardening resin in any one of the first through fifth solutions.

The seven solution is characterized in an electric /electronic component formed such that an insulating film is left on part of the metallic base material in a state in which the composite material in which the insulating film is provided at least on part of the metallic base material is bent after punching and the composite material is the composite material for use in the electric / electronic components described in any one of the solutions 1 through 6.

The eighth solution is characterized in that a wet post-processing is carried out on part where the insulating film is not provided in the state in which bending is carried out after punching.

The ninth solution is characterized in a method for manufacturing the composite material for use in the electric /electronic components in which the insulating film is provided at least on part of the metallic base material, forming the composite material for use in the electric / electronic components described in any one solution of the first through sixth solutions Claims by providing the metal layer that enhances the adhesion between the metallic base material and the insulating film by means of plating or the like.

The peel width of the insulating film at the end of the material after punching is measured by punching through samples into a rectangular shape of 5 mm x 10 mm by using a die of 5 % of clearance and by soaking the samples into an aqueous solution in which red ink is dissolved.

Further, the invention brings about the composite material for use in the electric / electronic components that keeps the high adhesive between the metallic base material and the insulating film even more easily by using also the following arrangements:
The metallic base material is made from copper or ferric material; A thickness of the metallic base material is decided to be in a range of 0.04 to 0.4m;
The metal layer is made by a metal selected from Ni, Zn, Fe, Cr, Sn, Si and Ti or by an alloy of those metals; and
A thickness of the metal layer is decided to be in a range of 0.001 to 0.5 µm.

The above other features and merits of the invention will be more apparent from the following description by appropriately making reference to the attached drawings.

### BRIEF DESCRIPTION OF DRAWINGS

[FIG. 1] FIG. 1 is a section view showing one exemplary composite material for electric / electronic components according to an embodiment of the invention.
[FIG. 2] FIG. 2 is a conceptual drawing showing one exemplary state in which gaps are created between a metallic base material and an insulating film.
[FIG. 3] FIG. 3 is a conceptual drawing showing one exemplary state in which gaps are created between a metallic base material and an insulating film.

### BEST MODE FOR CARRYING OUT THE INVENTION

FIG. 1 shows one exemplary cross-section of a composite material for electric / electronic components according to an embodiment of the invention. As shown in FIG. 1, the composite material for use in electric / electronic components 1 is provided with an insulating film 12 on a metallic base material 11 and with metal layers 13 between the metallic base material 11 and the insulating film 12 to enhance adhesion of the both. The metal layer 13 enhances the adhesion of the metallic base material 11 and the insulating film 12 and is preferable in terms of realizing the composite material for use in electric / electronic components 1 that excels in workability such as punching.

Although FIG. 1 shows the case in which the insulating film 12 is provided on part of an upper surface of the metallic base material 11 and on a whole lower surface of the metallic base material 11, this is one exemplary case to the end and the insulating film 12 may be provided on the whole upper and lower surfaces of the metallic base material 11 or may be provided on part of the upper and lower surfaces of the metallic base material 11. That is, the insulating film 12 is provided at least part of the metallic base material 11.

It is preferable to use a copper or iron material for the metallic base material 11 from an aspect of electrical conductivity and others. Beside copper-based alloys such as phosphor bronze (Cu-Sn-P), brass (Cu-Zn), nickel silver (Cu-Ni-Zn), Corson alloy (Cu-Ni-Si), oxygen-free copper, tough pitch copper, phosphorous-deoxidized copper and others are also applicable as the copper material. Still more, iron-based alloys such as SUS (Fe-Cr-Ni) and 42 alloy (Fe-Ni) are also applicable as the iron material.

A thickness of the metallic base material 11 is preferable to be 0.04 mm or more because enough strength as the electric /electronic component cannot be assured if the thickness is thinner than 0.04 mm. Still more, the thickness is preferable to be less than 0.4 mm or more preferably, to be less than 0.3 mm because an absolute value of a clearance increases in punching and a shear droop of the punched part increases if the thickness is too large. Thus, an upper limit of the thickness of the metallic base material 11 is decided by taking the influences (such as the clearance and the size of the shear droop) of machining such as punching into consideration.

It is preferable for the insulating film 12 to have adequate insulation, so that it is preferable to use resin such as epoxy resin. It is also preferable to form it with heat-resistant resin such as polyimide resin and polyamide resin when it is used in an application requiring heat resistance in particular. Among such heat-resistant resins, heat-hardening resin is preferable.

While it is preferable to use the organic material such as the aforementioned synthetic resins as the material of the insulating film 12, the material of the insulating film 12 may be appropriately selected corresponding to required characteristics and others of the composite material for use in electric /electronic components 1. For instance, the base material of the organic material such as the synthetic resin added with additives (either organic or nonorganic material may be used) other than the base material and non-organic materials may be adopted.

A method of providing the insulating film 12 on the surface of the metallic base material 11 through the intermediary of the metal layer 13 includes such methods of(a) placing an adhesive-backed heat-resistant resin film at part of the metallic base material requiring insulation, of melting the adhesive by an induction heating roll and of then implementing a heat treatment to reactively harden and bond them and (b) of applying melt varnish at the part requiring the insulation by using resin or resin precursor as a solvent, of evaporating the solvent and of then implement a heat-treatment to reactively harden and bond them. It is preferable to use the method (b) described above for the composite material for use in electric / electronic components 1 of the embodiment of the invention because it is not necessary to consider the influences of the adhesive.
It is noted that a concrete example of the method (b) described above is a general technology in a method for manufacturing insulated electric cables and is known also in Japanese Patent Application Laid-open No. Hei.5-130759 gazette and others. This gazette provides a plurality of layers of insulating coating and the present invention refers to this gazette as a reference technology.

Here, it is possible to repeat the method (b). It permits to fully evaporate the solvent and to reduce a possibility of generating bubbles between the insulating film 12 and the metal layer 13, so that the adhesion between the insulating film 12 and the metal layer 13 may be enhanced further. This method permits to provide substantially one layer of insulating film 12 on the metal layer 13 if the hardened resins formed separately in a plurality of times are substantially the same material.

Still more, when the insulating film 12 is to be provided on the part of the surface of the metallic base material 11, it is possible to adopt a manufacturing method that corresponds to a resin film forming accuracy level of the applied part such as a method of applying a roll coating facility for an offset (planographic) printing or a gravure (intaglio) printing, of applying coating of a photosensitive heat-resistant resin, pattern-forming by means of ultraviolet rays or electron beams and a resin hardening technology or of applying a micro-pattern forming technology applying etching and dissolution by an exposure phenomenon on a circuit board. Those methods make it easily possible to provide the insulating film 12 only on necessary parts of the surface of the metallic base material 11 and it becomes unnecessary to remove the insulating film 12 to connect the metallic base material 11 with other electric / electronic components or electric cables.

A thickness of the insulating film 12 is preferable to be from 2 to 20 µm and more preferably from 3 to 10 µm because it is unable to expect an insulating effect if the thickness is too thin and it becomes difficult to punch if the thickness is too thick.

The metal layer 13 is provided to enhance the adhesion between the metallic base material 11 and the insulating film 12 as described above. The adhesion of the metallic base material 11 and the insulating film 12 is preferable to be such that a peel width of the insulating film at the end of the material after punching is less than 10 µm or more preferably to be less than 5 µm.
The metal layer 13 is preferably formed by means of electroplating, chemical plating and the like and is preferably made of a metal selected among Ni, Zn, Fe, Cr, Sn, Si and Ti or of an alloy among those metals such as Ni-Zn alloy, Ni-Fe alloy and Fe-Cr alloy.

The metal layer 13 may be formed by means of wet or dry plating. The wet plating includes electrolytic plating and electroless plating methods for example. The dry plating includes physical vapor deposition and chemical vapor deposition methods for example.

A thickness of the metal layer 13 is preferable to be from 0.01 to 0.5 µm or more preferably from 0.005 to 0.5 µm because the adhesion of the metal layer 13 with the metallic base material 11 and the insulating film 12 is not enhanced if the thickness is too thin and because a possibility of causing cracks in the metal layer 13 increases if the thickness is too thick.

Still more, it is possible to implement a wet post-processing on part where no insulating film 12 is provided in the state in which the composite material for use in electric / electronic components 1 is bent after being machined by punching for example. The part where the insulating film 12 is not provided means sides of the metallic base material 11 in FIG. 1 and the part of the upper surface of the metallic base material 11 other than the part where the insulating film 12 is provided. A wet process used here includes wet plating (Ni plating, Sn plating, Au plating others), aqueous cleaning (acid pickling, alkali degreasing and others), solvent cleaning (supersonic cleaning and others) and others. For instance, although it is possible to protect the surface of the metallic base material 11 by proving a post-applied metal layer by means of the wet plating for example, the composite material for use in electric / electronic components 1 of the present embodiment has an advantage that the insulating film 12 does not peel from the metallic base material 11 even if the post-applied metal layer (not shown) is provided by the post-processing such as plating as a result of enhancing the adhesion between the metallic base material 11 and the insulating film 12.

While a thickness of the post-applied metal layer may be appropriately decided regardless of the thickness of the metal layer 13, its range may be from 0.001 to 0.5 µm in the same manner with the metal layer 13. Still more, while a metal used as the post-applied metal layer may be appropriately selected depending on uses of the electric / electronic component, it is preferable to be Au, Ag, Cu, Ni and Sn or an alloy containing them when the electric / electronic component is used as an electrical contact, a connector and the like.

According to the invention, the metal layer that enhances the adhesion between the metallic base material and the insulating film is interposed between the metallic base material and the insulating film, so that it is possible to keep the high adhesion between the metallic base material and the insulating film even if bending is carried out after punching the part including the interface of the metallic base material with the insulating film (specifically the interface of the metallic base material with the metal layer and the interface of the metal layer with the insulating film) and to obtain the composite material for the electric /electronic component that excels in the workability such as punching and bending.

Still more, the electric / electronic component of the invention is formed so that the insulating film is left on part of the metallic base material in the state in which the composite material provided with the insulating film at least on part of the metallic base material is bent after being punching and uses the material in which the metal layer that enhances the adhesion between the metallic base material and the insulating film as the composite material for use in the electric / electronic component, so that it is possible to readily obtain the electric / electronic component in which the insulating film adheres with the metallic base material through the metal layer and that excels in the workability such as punching and bending.

Further, because the metallic base material adheres tightly with the insulating film in the electric / electronic component of the invention, the insulating film will not peel from the metallic base material by providing the post-applied metal layer by means of the post-processing such as plating at the part where the insulating film is not provided.

The method of the invention for manufacturing the composite material for use in the electric / electronic component is carried out by providing the metal layer that enhances the adhesion between the metallic base material and the insulating film by means of plating or the like, so that it is possible to keep the high adhesion between the metallic base material and the insulating film even if bending is carried out after punching the part including the interface of the metallic base material with the insulating film (specifically the interface of the metallic base material with the metal layer and the interface of the metal layer with the insulating film) and to obtain the composite material for the electric /electronic component that excels in the workability such as punching and bending.

Although the invention will be explain in more detail below, the invention is not limited to them.

### EMBODIMENTS

### [First Embodiment]

### (Explanation of Samples)

As specific examples of the invention, the inventor, et al. implemented the electrolytic degreasing and acid pickling treatments in this order on metal strips (metallic base material) having a thickness of 0.1 mm and a width of 10 mm. Then, the inventor, et al. implemented Ni plating, Zn plating, Fe plating, Cr plating, Sn plating, Ni-Zn alloy plating, Ni-Fe alloy plating, Fe-Cr alloy plating, Si plating and Ti plating respectively with thicknesses of 0.001 µm, 0.005 µm, 0.01 µm, 0.05 µm, 0.1 µm and 0.5 µm and provided insulating coating layers at part of each strip requiring insulation to manufacture the composite materials for use in the electric / electronic components. The metal strip used was JIS alloy C5210R (phosphor bronze: made by the Furukawa Electric Co., Ltd.). It is noted that the inventor, et al. measured the plating thickness in terms of an average value of ten samples by using an X-ray fluorescence thickness meter SFT-3200 (made by Seiko-Epson Precision Co.).
Still more, beside those described above and as comparative examples, the inventor, et al. implemented the electrolytic degreasing and acid pickling treatments in this order and manufactured composite materials for use in electric / electronic components by providing the insulating coating layer at part requiring insulation without implementing plating. The inventor, et Al. also manufactured composite materials for use in electric / electronic components in the same manner with the examples described above except of plating by 1.0 µm as a still other comparative example.

### (Various Conditions)

The electrolytic degreasing treatment was carried out by implementing cathode-electrolysis on the metal strip for 30 seconds under conditions of 60°C of liquid temperature and 2.5A/dm² of current density within a degreasing solution containing 60 g/l of cleaner 160S (made by Meltex Inc.).
The acid pickling treatment was carried out on the metal strip by soaking it into an acid pickling solution containing 100 g/l of sulfuric acid for 30 seconds in room temperature.
The Ni plating was carried out under conditions of 55 °C of liquid temperature and 10 A/dm² of current density within a plating solution containing 400 g/l of nickel sulfamite, 30 g/l of nickel chloride and 30 g/l of boric acid while adjusting a length of a plating tank and lining speed so that the plating grows to a predetermined thickness.
The Zn plating was carried out under conditions of 45 °C of liquid temperature and 20 A/dm² of current density within a plating solution containing 350 g/l of zinc sulfate and 30 g/l of ammonium sulfate while adjusting the length of the plating tank and lining speed so that the plating grows to a predetermined thickness.
The Fe plating was carried out under conditions of 60 °C of liquid temperature and 30 A/dm² of current density within a plating solution containing 400 g/l of ferric sulfate, 50 g/l of ammonium sulfate and 80 g/l of urea while adjusting the length of the plating tank and lining speed so that the plating grows to a predetermined thickness.
The Cr plating was carried out under conditions of 55 °C of liquid temperature and 20 A/dm² of current density within a plating solution containing 250 g/l of chromic anhydride and 2.5 g/l of sulfuric acid while adjusting the length of the plating tank and lining speed so that the plating grows to a predetermined thickness.
The Sn plating was carried out under conditions of 25 °C of liquid temperature and 2 A/dm² of current density within a plating solution containing 55 g/l of tin sulfate and 100 g/l of sulfuric acid while adjusting the length of the plating tank and lining speed so that the plating grows to a predetermined thickness.
The Ni-Zn alloy plating was carried out under conditions of 25 °C of liquid temperature and 0.2 A/dm² of current density within a plating solution containing 75 g/l of nickel chloride, 30 g/l of zinc chloride, 30 g/l of ammonium chloride and 15 g/l of sodium thiocyanate while adjusting the length of the plating tank and lining speed so that the plating grows to a predetermined thickness.
The Ni-Fe alloy plating was carried out under conditions of 50 °C of liquid temperature and 5 A/dm² of current density within a plating solution containing 250 g/l of nickel sulfate, 50 g/l of ferric sulfate and 30 g/l of boric acid while adjusting the length of the plating tank and lining speed so that the plating grows to a predetermined thickness.
The Fe-Cr alloy plating was carried out under conditions of 45 °C of liquid temperature and 20 A/dm² of current density within a plating solution containing 40 g/l of ferric sulfate, 120 g/l of chrome sulfate, 55 g/l of ammonium chloride and 40 g/l of boric acid while adjusting the length of the plating tank and lining speed so that the plating grows to a predetermined thickness.
The Si plating and the Ti plating were carried out by means of PVD by using a take-up type sputtering device SPW-069 (made by Alback Co.).
The insulating coating layer was formed by perpendicularly discharging varnish (fluid applied substance) on the surface of the running metallic base material out of a rectangular discharging port of an applicator and by heating it for 30 seconds at 300 °C. The varnish was produced so that a thickness of the resin grows to a range from 8 to 10 µm by using a polyimide (PAI) solution using n-methyl 2-pyrolidone as solvent (made by Totoku Toryo Co. Ltd.,). It is noted that the inventor et al. obtained the same results also from samples formed so that the thickness of the resin grows to the range from 8 to 10 µm by using a polyimide (PI) solution using n-methyl 2-pyrolidone (made by Arakawa Chemical Industries Ltd.) and an epoxy resin solution using methyl ethyl ketone (made by Dai Nippon Toryo Co., Ltd.).

### (Evaluation Result)

The evaluation of the punching and bending workability of the composite materials for use in the electric / electronic components thus obtained was made as follows.
The punching workability was evaluated by punching through the samples into a rectangular shape of 5 mm x 10 mm by using a die of 5 % of clearance and by soaking the samples into an aqueous solution in which red ink is dissolved. Cases when the peel width of the resin at the punched end is less than 5 µm were denoted by □, cases when the peel width is more than 5 µm and less than 10 µm are denoted by ○ and cases when the width is more than 10 µm are denoted by x.
The evaluation of the bending workability was determined by punching through the samples into the rectangular shape of 5 mm x 10 mm by using the die of 5 % of clearance and then by bending so that the samples are bent at position of 1 mm from the end of the samples by using a die having 0.1 mm of radius of curvature and 120 degrees of bending angle and by observing whether or not the resin is peeled at the bending inner side and whether or not the resin at the end portion to which the bending outer side is extended is peeled by an optical stereoscopic microscope of 40 times power. Cases when there is no peeling (those whose adhesion state of the resin are kept) are denoted by ○ and cases when there exist peeling (those whose adhesion state of the resin are not kept) are denoted by x. In the same time, it was observed whether or not there exist cracks of the plating substrate in the bent portion and the plating bending quality was evaluated by ○ and x. Table 1 shows those results.

**[Table 1]**

| base material : phosphorus bronze | | | | | | |
|---|---|---|---|---|---|---|
| | Sample No. | Type of Plating | Thickness of Plating [µm] | Evaluation of Punching Workability | Evaluation of Bending Workability ((inside/outside) | Plating Bending Workability |
| | 1 | Ni | 0.001 | ⊚ | ○/○ | ○ |
| | 2 | | 0.005 | ⊚ | ○/○ | ○ |
| | 3 | | 0.01 | ⊚ | ○/○ | ○ |
| | 4 | | 0.05 | ⊚ | ○/○ | ○ |
| | 5 | | 0.1 | ⊚ | ○/○ | ○ |
| | 6 | | 0.5 | ⊚ | ○/○ | ○ |
| | 7 | Zn | 0.001 | ⊚ | ○/○ | ○ |
| | 8 | | 0.005 | ⊚ | ○/○ | ○ |
| | 9 | | 0.01 | ⊚ | ○/○ | ○ |
| | 10 | | 0.05 | ⊚ | ○/○ | ○ |
| | 11 | | 0.1 | ⊚ | ○/○ | ○ |
| | 12 | | 0.5 | ⊚ | ○/○ | ○ |
| | 13 | Fe | 0.001 | ○ | ○/○ | ○ |
| | 14 | | 0.005 | ○ | ○/○ | ○ |
| | 15 | | 0.01 | ○ | ○/○ | ○ |
| | 16 | | 0.05 | ⊚ | ○/○ | ○ |
| | 17 | | 0.1 | ⊚ | ○/○ | ○ |
| | 18 | | 0.5 | ○ | ○/○ | ○ |
| | 19 | Cr | 0.001 | ○ | ○/○ | ○ |
| | 20 | | 0.005 | ○ | ○/○ | ○ |
| | 21 | | 0.01 | ○ | ○/○ | ○ |
| | 22 | | 0.05 | ⊚ | ○/○ | ○ |
| | 23 | | 0.1 | ⊚ | ○/○ | ○ |
| | 24 | | 0.5 | ○ | ○/○ | ○ |
| | 25 | Sn | 0.001 | ○ | ○/○ | ○ |
| | 26 | | 0.005 | ⊚ | ○/○ | ○ |
| | 27 | | 0.01 | ⊚ | ○/○ | ○ |
| | 28 | | 0.05 | ⊚ | ○/○ | ○ |
| | 29 | | 0.1 | ⊚ | ○/○ | ○ |
| Present | 30 | | 0.5 | ○ | ○/○ | ○ |
| Invention | 31 | Ni-Zn | 0.001 | ⊚ | ○/○ | ○ |
| | 32 | | 0.005 | ⊚ | ○/○ | ○ |
| | 33 | | 0.01 | ⊚ | ○/○ | ○ |
| | 34 | | 0.05 | ⊚ | ○/○ | ○ |
| | 35 | | 0.1 | ⊚ | ○/○ | ○ |
| | 39 | | 0.5 | ○ | ○/○ | ○ |
| | 37 | Ni-Fe | 0.001 | ○ | ○/○ | ○ |
| | 38 | | 0.005 | ⊚ | ○/○ | ○ |
| | 39 | | 0.01 | ⊚ | ○/○ | ○ |
| | 40 | | 0.05 | ⊚ | ○/○ | ○ |
| | 41 | | 0.1 | ⊚ | ○/○ | ○ |
| | 42 | | 0.5 | ○ | ○/○ | ○ |
| | 43 | Fe-Cr | 0.001 | ○ | ○/○ | ○ |
| | 44 | | 0.005 | ○ | ○/○ | ○ |
| | 45 | | 0.01 | ○ | ○/○ | ○ |
| | 46 | | 0.05 | ⊚ | ○/○ | ○ |
| | 47 | | 0.1 | ⊚ | ○/○ | ○ |
| | 48 | | 0.5 | ○ | ○/○ | ○ |
| | 49 | Si | 0.001 | ○ | ○/○ | ○ |
| | 50 | | 0.005 | ○ | ○/○ | ○ |
| | 51 | | 0.01 | ⊚ | ○/○ | ○ |
| | 52 | | 0.05 | ⊚ | ○/○ | ○ |
| | 53 | | 0.1 | ⊚ | ○/○ | ○ |
| | 54 | | 0.5 | ○ | ○/○ | ○ |
| | 55 | Ti | 0.001 | ○ | ○/○ | ○ |
| | 56 | | 0.005 | ⊚ | ○/○ | ○ |
| | 57 | | 0.01 | ⊚ | ○/○ | ○ |
| | 58 | | 0.05 | ⊚ | ○/○ | ○ |
| | 59 | | 0.1 | ⊚ | ○/○ | ○ |
| | 60 | | 0.5 | ○ | ○/○ | ○ |
| | 61 | Non Plated | | × | ×/× | --- |
| | 62 | Ni | 1 | ⊚ | ○/○ | × |
| | 63 | Zn | 1 | ⊚ | ○/○ | × |
| | 64 | Fe | 1 | ⊚ | ○/○ | × |
| | 65 | Cr | 1 | ⊚ | ○/○ | × |
| Comparative | 66 | Sn | 1 | ⊚ | ○/○ | × |
| Examples | 67 | Ni-Zn | 1 | ⊚ | ○/○ | × |
| | 68 | Ni-Fe | 1 | ⊚ | ○/○ | × |
| | 69 | Fe-Cr | 1 | ⊚ | ○/○ | × |
| | 70 | Si | 1 | ⊚ | ○/○ | × |
| | 71 | Ti | 1 | ⊚ | ○/○ | × |

The sample No. 61 of the comparative examples has inferior punching and bending workability of the resin because no base plating process is implemented. Although the comparative examples 62 through 71 excel in the punching bending workability of the resin, the plating part cracks because the plating layer is thick. In contrary, the sample Nos. 1 through 60 of the invention excel in the punching and bending workability of the resin and the plating part causes no cracks, so that they are suitable for use in those machined by a precision press and are even more suitable for use in those requiring bending. Specifically, the sample Nos. 1 through 12 on which the Ni plating and the Zn plating were implemented bring about excellent effects even in the regions where the thickness of the plating is thin.

### [Second Embodiment]

The evaluation was carried out in the same manner with the first embodiment except of that JIS alloy C7701 (nickel silver, made by Mitsubishi Metex Co., Ltd.) was used as the metal strip. Table 2 shows its results.

**[Table 2]**

| base material : nilckel silver | | | | | | |
|---|---|---|---|---|---|---|
| | Sample No | Type of Plating | Thickness of plating [µm] | Evaluation of Punching Workability | Evaluation of Bending Workability ((inside/outside) | Plating Bending Workability |
| | 72 | Ni | 0.001 | ⊚ | ○/○ | ○ |
| | 73 | | 0.005 | ⊚ | ○/○ | ○ |
| | 74 | | 0.001 | ⊚ | ○/○ | ○ |
| | 75 | | 0.05 | ⊚ | ○/○ | ○ |
| | 76 | | 0.1 | ⊚ | ○/○ | ○ |
| | 77 | | 0.5 | ⊚ | ○/○ | ○ |
| | 78 | Zn | 0.001 | ⊚ | ○/○ | ○ |
| | 79 | | 0.005 | ⊚ | ○/○ | ○ |
| | 80 | | 0.01 | ⊚ | ○/○ | ○ |
| | 81 | | 0.05 | ⊚ | ○/○ | ○ |
| | 82 | | 0.1 | ⊚ | ○/○ | ○ |
| | 83 | | 0.5 | ⊚ | ○/○ | ○ |
| | 84 | Fe | 0.001 | ○ | ○/○ | ○ |
| | 85 | | 0.005 | ○ | ○/○ | ○ |
| | 86 | | 0.01 | ○ | ○/○ | ○ |
| | 87 | | 0.05 | ⊚ | ○/○ | ○ |
| | 88 | | 0.1 | ○ | ○/○ | ○ |
| | 89 | | 0.5 | ○ | ○/○ | ○ |
| | 90 | Cr | 0.001 | ○ | ○/○ | ○ |
| | 91 | | 0.005 | ⊚ | ○/○ | ○ |
| | 92 | | 0.01 | ⊚ | ○/○ | ○ |
| | 93 | | 0.05 | ⊚ | ○/○ | ○ |
| | 94 | | 0.1 | ⊚ | ○/○ | ○ |
| | 95 | | 0.5 | ○ | ○/○ | ○ |
| | 96 | Sn | 0.001 | ○ | ○/○ | ○ |
| | 97 | | 0.005 | ○ | ○/○ | ○ |
| | 98 | | 0.01 | ○ | ○/○ | ○ |
| | 99 | | 0.05 | ⊚ | ○/○ | ○ |
| | 100 | | 0.1 | ⊚ | ○/○ | ○ |
| Present | 101 | | 0.5 | ⊚ | ○/○ | ○ |
| Invention | 102 | Ni-Zn | 0.001 | ⊚ | ○/○ | ○ |
| | 103 | | 0.005 | ⊚ | ○/○ | ○ |
| | 104 | | 0.01 | ⊚ | ○/○ | ○ |
| | 105 | | 0.05 | ⊚ | ○/○ | ○ |
| | 106 | | 0.1 | ⊚ | ○/○ | ○ |
| | 107 | | 0.5 | ○ | ○/○ | ○ |
| | 108 | Ni-Fe | 0.001 | ○ | ○/○ | ○ |
| | 109 | | 0.005 | ⊚ | ○/○ | ○ |
| | 110 | | 0.01 | ⊚ | ○/○ | ○ |
| | 111 | | 0.05 | ⊚ | ○/○ | ○ |
| | 112 | | 0.1 | ⊚ | ○/○ | ○ |
| | 113 | | 0.5 | ○ | ○/○ | ○ |
| | 114 | Fe-Cr | 0.001 | ○ | ○/○ | ○ |
| | 115 | | 0.005 | ○ | ○/○ | ○ |
| | 116 | | | ○ | ○/○ | ○ |
| | 117 | | 0.05 | ○ | ○/○ | ○ |
| | 118 | | 0.1 | ⊚ | ○/○ | ○ |
| | 119 | | 0.5 | ○ | ○/○ | ○ |
| | 120 | Si | 0.001 | ○ | ○/○ | ○ |
| | 121 | | 0.005 | ○ | ○/○ | ○ |
| | 122 | | 0.01 | ⊚ | ○/○ | ○ |
| | 123 | | 0.05 | ⊚ | ○/○ | ○ |
| | 124 | | 0.1 | ⊚ | ○/○ | ○ |
| | 125 | | 0.5 | ○ | ○/○ | ○ |
| | 126 | Ti | 0.001 | ○ | ○/○ | ○ |
| | 127 | | 0.005 | ⊚ | ○/○ | ○ |
| | 128 | | 0.01 | ⊚ | ○/○ | ○ |
| | 129 | | 0.05 | ⊚ | ○/○ | ○ |
| | 130 | | 0.1 | ⊚ | ○/○ | ○ |
| | 131 | | 0.5 | ○ | ○/○ | ○ |
| | 132 | Non-plated | | × | ×/× | --- |
| | 133 | Ni | 1 | ⊚ | ○/○ | × |
| | 134 | Zn | 1 | ⊚ | ○/○ | × |
| | 135 | Fe | 1 | | ○/○ | × |
| Comparative | 136 | Cr | 1 | ⊚ | ○/○ | × |
| Examples | 137 | Sn | 1 | ⊚ | ○/○ | × |
| | 138 | Ni-Zn | 1 | ⊚ | ○/○ | × |
| | 139 | Ni-Fe | 1 | ⊚ | ○/○ | × |
| | 140 | Fe-Cr | 1 | ⊚ | ○/○ | × |
| | 141 | Si | 1 | ⊚ | ○/○ | × |
| | 142 | Ti | 1 | ⊚ | ○/○ | × |

The sample No. 132 of the comparative examples has inferior punching and bending workability of the resin because no base plating process is implemented. Although the comparative examples 132 through 142 excel in the punching bending workability of the resin, the plating part cracks because the plating layer is thick. In contrary, the sample Nos. 72 through 131 of the invention excel in the punching and bending workability of the resin and the plating part causes no cracks, so that they are suitable for use in those machined by a precision press and are even more suitable for use in those requiring bending. Specifically, the sample Nos. 72 through 83 on which the Ni plating and the Zn plating were implemented bring about excellent effects even in the regions where the thickness of the plating is thin. That is, the sample Nos. 72 through 131 of the second embodiment excel in the punching workability of the resin in the same manner with the first embodiment, so that they are suitable in the use of those machined by the precision press and more suitable in the use of those requiring bending.

### [Third Embodiment]

The evaluation was carried out in the same manner with the first embodiment except of that SUS304-CPS (stainless, made by Nisshi Steel Co., Ltd.) was used as the metal strip. Table 3 shows its results.

**[Table 3]**

| base material: stainless steel | | | | | | |
|---|---|---|---|---|---|---|
| | Sample No. | Type of Plating | Thickness of Plating [µm] | Evaluation of Punching Workability | Evaluation of Bending Workability (inside/outside) | Plating Bending Workability |
| | 143 | Ni | 0.001 | ⊚ | ○/○ | ○ |
| | 144 | | 0.005 | ⊚ | ○/○ | ○ |
| | 145 | | 0.01 | ⊚ | ○/○ | ○ |
| | 146 | | 0.05 | ⊚ | ○/○ | ○ |
| | 147 | | 0.1 | ⊚ | ○/○ | ○ |
| | 148 | | 0.5 | ⊚ | ○/○ | ○ |
| | 149 | Zn | 0.001 | ⊚ | ○/○ | ○ |
| | 150 | | 0.005 | ⊚ | ○/○ | ○ |
| | 151 | | 0.01 | ⊚ | ○/○ | ○ |
| | 152 | | 0.05 | ⊚ | ○/○ | ○ |
| | 153 | | 0.1 | ⊚ | ○/○ | ○ |
| | 154 | | 0.5 | ○ | ○/○ | ○ |
| | 155 | Fe | 0.001 | ○ | ○/○ | ○ |
| | 156 | | 0.005 | ⊚ | ○/○ | ○ |
| | 157 | | 0.01 | ⊚ | ○/○ | ○ |
| | 158 | | 0.05 | ⊚ | ○/○ | ○ |
| | 159 | | 0.1 | ⊚ | ○/○ | ○ |
| | 160 | | 0.5 | ○ | ○/○ | ○ |
| | 161 | Cr | 0.001 | ○ | ○/○ | ○ |
| | 162 | | 0.005 | ⊚ | ○/○ | ○ |
| | 163 | | 0.01 | ⊚ | ○/○ | ○ |
| | 164 | | 0.05 | ⊚ | ○/○ | ○ |
| | 165 | | 0.1 | ⊚ | ○/○ | ○ |
| | 166 | | 0.5 | ○ | ○/○ | ○ |
| | 167 | Sn | 0.001 | ○ | ○/○ | ○ |
| | 168 | | 0.005 | ○ | ○/○ | ○ |
| | 169 | | 0.01 | ○ | ○/○ | ○ |
| | 170 | | 0.05 | ⊚ | ○/○ ○ | ○ |
| Present | 171 | | 0.1 | ⊚ | ○/○ | ○ |
| Invention | 172 | | 0.5 | ○ | ○/○ | ○ |
| | 173 | Ni-Zn | 0.001 | ⊚ | ○/○ | ○ |
| | 174 | | 0005 | ⊚ | ○/○ | ○ |
| | 175 | | 0.01 | ⊚ | ○/○ | ○ |
| | 176 | | 0.05 | ⊚ | ○/○ | ○ |
| | 177 | | 0.1 | ⊚ | ○/○ | ○ |
| | 178 | | 0.5 | ○ | ○/○ | ○ |
| | 179 | Ni-Fe | 0.001 | ○ | ○/○ | ○ |
| | 180 | | 0.005 | ⊚ | ○/○ | ○ |
| | 181 | | 0.01 | ⊚ | ○/○ | ○ |
| | 182 | | 0.05 | ⊚ | ○/○ | ○ |
| | 183 | | 0.1 | ⊚ | ○/○ | ○ |
| | 184 | | 0.5 | ○ | ○/○ | ○ |
| | 185 | Fe-Cr | 0.001 | ○ | ○/○ | ○ |
| | 186 | | 0.005 | ⊚ | ○/○ | ○ |
| | 187 | | 0.01 | ⊚ | ○/○ | ○ |
| | 188 | | 0.05 | ⊚ | ○/○ | ○ |
| | 189 | | 0.1 | ⊚ | ○/○ | ○ |
| | 190 | | 0.5 | ○ | ○/○ | ○ |
| | 191 | Si | 0.001 | ○ | ○/○ | ○ |
| | 192 | | 0.005 | ○ | ○/○ | ○ |
| | 193 | | 0.01 | ⊚ | ○/○ | ○ |
| | 194 | | 0.05 | ⊚ | ○/○ | ○ |
| | 195 | | 0.1 | ⊚ | ○/○ | ○ |
| | 196 | | 0.5 | ○ | ○/○ | ○ |
| | 197 | Ti | 0.001 | ○ | ○/○ | ○ |
| | 198 | | 0.005 | ○ | ○/○ | ○ |
| | 199 | | 0.01 | ⊚ | ○/○ | ○ |
| | 200 | | 0.05 | ⊚ | ○/○ | ○ |
| | 201 | | 0.1 | ⊚ | ○/○ | ○ |
| | 202 | | 0.5 | ○ | ○/○ | ○ |
| | 203 | Non-Plated | | × | ×/× | --- |
| | 204 | Ni | 1 | ⊚ | ○/○ | × |
| | 205 | Zn | 1 | ⊚ | ○/○ | × |
| | 206 | Fe | 1 | ⊚ | ○/○ | × |
| Comparatve | 207 | Cr | 1 | ⊚ | ○/○ | × |
| Examples | 208 | Sn | 1 | ⊚ | ○/○ | × |
| | 209 | Ni-Zn | 1 | ⊚ | ○/○ | × |
| | 210 | Ni-Fe | 1 | ⊚ | ○/○ | × |
| | 211 | Fe-Cr | 1 | ⊚ | ○/○ | × |
| | 212 | Si | 1 | ⊚ | ○/○ | × |
| | 213 | Ti | 1 | ⊚ | ○/○ | × |

The sample No. 203 of the comparative examples has inferior punching and bending workability of the resin because no base plating process is implemented. Although the comparative examples No. 204 through 213 excel in the punching bending workability of the resin, the plating part cracks because the plating layer is thick. In contrary, the sample Nos. 143 through 202 of the invention excel in the punching and bending workability of the resin and the plating part causes no cracks, so that they are suitable for use in those machined by the precision press and are even more suitable for use in those requiring bending. Specifically, the sample Nos. 143 through 152 on which the Ni plating and the Zn plating were implemented bring about excellent effects even in the regions where the thickness of the plating is thin. That is, the sample Nos. 143 through 202 of the third embodiment excel in the punching workability of the resin in the same manner with the first embodiment, so that they are suitable in the use of those machined by the precision press and more suitable in the use of those requiring bending.

### INDUSTRIAL APPLICABILITY

The composite material for use in the electric / electronic components of the invention keeps the high adhesion state of the metallic base material and the insulating film even if the bending is implemented after punching at the part including the interface between the metallic base material and the insulating film, so that it is suitable as the composite material for use in the electric / electronic component that excels in the workability such as punching and bending.

Although the invention has been explained in conjunction with the embodiments thereof, the invention does not limit any detail of the explanation thereof unless specifically specified and the invention described in the appended Claims should be widely construed without departing from the sprit and scope described in the appended Claims.
The present application claims the foreign priority benefit of Japanese Patent Application No. 2006-350875, filed on December 27, 2006 in the Japan Patent Office and Japanese Patent Application No. 2007-333316, filed on December 25, 2007 in the Japan Patent Office, the disclosures of which are herein incorporated by reference in its entirety.

## Claims

1. A composite material for use as a material in electric /electronic components formed by punching followed by bending and provided substantially with one layer of an insulating film at least on part of a metallic base material, wherein a metal layer is provided between the metal layer and the insulating film so that a peel width of the insulating film at an end of the material after punching is less than 10 µm and so that an adhesion state of the insulating film in a bending inner side of the material after bending and an adhesion state of the insulating film at the end to which the bending outer side is extended are both kept.

2. The composite material for use in the electric / electronic components according to Claim 1, wherein the metallic base material is made of copper material or ferric material.

3. The composite material for use in the electric / electronic components according to Claim 1 or 2, wherein a thickness of the metallic base material is from 0.04 to 0.4 mm.

4. The composite material for use in the electric / electronic components according to Claim 1, wherein the metal layer is made of a metal selected among Ni, Zn, Fe, Dr, Sn, Si and Ti or of an alloy of those metals.

5. The composite material for use in the electric / electronic components according to Claim 4, wherein a thickness of the metal layer is from 0.001 to 0.5 µm.

6. The composite material for use in the electric / electronic components according to any one of Claims 1 - 5, wherein the insulating film is made of a heat hardening resin.

7. An electric / electronic component formed such that an insulating film is left on part of the metallic base material in a state in which the composite material in which the insulating film is provided at least on part of the metallic base material is bent after punching and the composite material is the composite material for use in the electric / electronic components described in any one of Claims 1 through 6.

8. The electric / electronic component according to Claim 7, wherein a wet post-processing is carried out on part where the insulating film is not provided in the state in which bending is carried out after punching.

9. A method for manufacturing the composite material for use in the electric / electronic components in which the insulating film is provided at least on part of the metallic base material, forming the composite material for use in the electric / electronic components described in any one of Claims 1 through 6 by providing the metal layer that enhances the adhesion between the metallic base material and the insulating film by means of plating or the like.
